# EUROPEAN PATENT APPLICATION

(11) **EP 2 058 702 A1**
(43) Date of publication of application: **13.05.2009**
(21) Application number: 07792502.2
(22) Date of filing: 14.08.2007
(51) Int. Cl.: G03F 7/004, G02B 5/32, G03H 1/02

(54) **PHOTOSENSITIVE COMPOSITION COMPRISING ORGANIC-ZIRCONIA COMPOSITE MICROPARTICLE**

(30) Priority: 25.08.2006 JP 2006229362
(71) Applicant: National University Corporation The University of Electro - Communications, Chofu-shi, Tokyo 182-8585 (JP); Nissan Chemical Industries, Ltd., Chiyoda-ku, Tokyo 101-0054 (JP)
(72) Inventor: TOMITA, Yasuo, Tokyo 182-8585 (JP); SUZUKI, Naoaki, Tokyo 182-8585 (JP); HIDAKA, Motohiko, Chiba 274-8507 (JP); OHMORI, Kentaro, Chiba 274-8507 (JP); ODOI, Keisuke, Tokyo 101-0054 (JP)
(74) Representative: HOFFMANN EITLE
(86) International application number: PCT/JP2007/065859
(87) International publication number: WO 2008/023612

(57) **Abstract**

[Problems]

The present invention provides a photosensitive composition capable of permanently forming a hologram having a low light scattering loss and high diffraction efficiency, and a forming method of a pattern.

[Means for solving problems]

A photosensitive composition used for forming a pattern by a pattern exposure containing (a) a polymerizable compound, (b) a photopolymerization initiator, and (c) organic-zirconia composite fine particles having a zirconia volume concentration of 20% by volume to 80% by volume; and a forming method of a pattern using the composition.

## Description

### TECHNICAL FIELD

The present invention relates to: a photosensitive composition capable of forming a pattern in which by subjecting the composition to a pattern exposure, the movement of each component in the composition is caused and a spatial distribution of each component is changed; a method for forming a pattern using the composition; a composition for a hologram recording material for a hologram recording layer in which the photosensitive composition records a volume phase hologram; the hologram recording layer; and a volume phase hologram recording medium including the hologram recording layer.

### BACKGROUND ART

A holographic diffraction grating (hologram) is a recorded matter in which light and dark (interference) patterns of light are recorded in a photosensitive material or the like as patterns of a refractive index or absorptivity, and since they have multiple performances, a large number of applications thereof are reported in wide fields such as photonics and information displays, for example a diffraction optical element, a holographic optical memory, a narrow band wavelength filter, a photonic crystal, an optical waveguide coupler, an optical interconnection, a stereoscopic image display and a heads-up display.
In these applications, a high refractive index change and a high recording sensitivity are usually required. In addition, in order to prevent a deterioration of reproduced light quality caused by a mechanical distortion of a recorded hologram due to a polymerization shrinkage following a polymerization caused during a holographic exposure, low polymerization shrinkability is also required.

As conventional representative compositions for hologram recording materials, dichromated gelatin photosensitive materials and silver halide photosensitive materials subjected to a bleaching treatment have been used. While these materials have high diffraction efficiency, have also such drawback as that the treatment thereof at the time of forming a hologram is complicated and particularly they are necessary to be subjected to a wet developing treatment.
As dry hologram photosensitive materials for overcoming the drawback, Omni Dex series (manufactured by DuPont) are widely known. This material contains as main components, a radical polymerization monomer and a binder polymer, a photo radical polymerization initiator and a sensitizing dye and is for recording a hologram by utilizing the difference in the refractive index between the radical polymerization monomer and the binder polymer. In other words, when the photosensitive composition formed in a film shape is subjected to interference exposure to light, in a portion of the composition exposed to strong light, a radical polymerization is initiated, following which a concentration gradient of a radical polymerization monomer is caused, so that a diffusion movement of the radical polymerization monomer from a portion of the composition exposed to weak light to a portion thereof exposed to strong light, is caused. As a result, according to intensity of interference light, condensation or rarefaction of the density of the radical polymerization monomer and of the density of the polymerized polymer is caused, so that as a difference of a refractive index between them and the binder polymer, a hologram is formed. Though this material system has high performance as a photopolymer for a hologram reported in the present state, a problem that the thickness thereof is limited to around 30 µm and problems in heat resistance and transparency, are pointed out.

In addition, a material system in which a radical polymerization and a cationic polymerization are performed in combination (see Patent Document 1) and a material system utilizing a cationic polymerization (see Patent Document 2), are reported. However, these material systems are constituted only of organic materials and the polymers are not dissolved in each other at a molecule level, so that there are such issues that, in a hologram recording film formed of these material systems, lowering of transparency due to a phase separation occurs and a light scattering loss is increased based on it. Further, they are yet unsatisfactory in mechanical strength and environmental stability.
A material system using an inorganic substances network and photopolymerizable monomers in combination is also disclosed (see Patent Document 3). When an inorganic material capable of forming a network is used as a binder, while there are such advantages as being excellent in heat resistance, environment resistance and mechanical strength, and capable of causing the difference in a refractive index between the binder and a photopolymerizable organic monomer to be large, there are such issues that a hologram recording film formed in this material system is rather brittle and is poor in flexibility, processability and coating suitability, and that since the compatibility between the inorganic binder and the organic monomer is poor, it is difficult to prepare a homogeneous coating material.

In addition, a material in which metal ultrafine particles are dispersed in a solid matrix is disclosed as a hologram recording material (see Patent Document 4). However, in this invention, it is necessary to impart fluidity to a matrix, and not only solidity is poor but also interface adhesion between interface of metal particles and a solid matrix is poor, so that there are such issues that the material becomes brittle and also that water invades into the interface.
A hologram recording material in which organic-inorganic hybrid polymers and organic metal fine particles having photopolymerization reactive groups are used, is also disclosed (see Patent Document 5). However, in this invention, application of heat and ultraviolet polymerization are necessary to fix an interference pattern, so that there is a task remained as an industrial process.

As a material for performing a hologram recording by a more simple method, a hologram recording material in which inorganic fine particles are dispersed in photopolymerizable monomers is disclosed (see Patent Document 6, Patent Document 7 and Non-patent Document 1). However, in this invention, since used inorganic fine particles have a large particle diameter and a wide particle diameter distribution range, and further the inorganic fine particles are likely to be aggregated to each other, there is a disadvantage such that a light scattering loss is large.
[Patent Document 1]
   Japanese Patent Application Publication No. JP-A-5-107999 (Claims)
[Patent Document 2]
   US Patent No. 5759721 Specification (Full-text)
[Patent Document 3]
   Japanese Patent Application Publication No. JP-A-6-019040 (Claims)
[Patent Document 4]
   Published Japanese Translation of PCT Application No. 2000-508783 (Claims)
[Patent Document 5]
   Japanese Patent Application Publication No. JP-A-2002-236440 (Claims)
[Patent Document 6]
   Japanese Patent Application Publication No. JP-A-2003-84651 (Claims)
[Patent Document 7]
   Japanese Patent Application Publication No. JP-A-2005-099612 (Claims)
[Non-patent Document 1]
   "Applied Physics Letters (Appl. Phys. Lett.)", USA, 2002, vol. 81, pp. 4121-4123

### DISCLOSURE OF THE INVENTION

### [Problem to be Solved by the Invention]

It is an object of the present invention to provide: a photosensitive composition capable of permanently forming a hologram in which a light scattering loss is extremely low and diffraction efficiency is high by using organic-zirconia composite fine particles to suppress the aggregation of fine particles to each other; and a forming method of the hologram.

### [Means for Solving the Problem]

The present inventors have made extensive and intensive studies and as a result, they found that an excellent holographic diffraction grating (hologram) can be obtained from a photosensitive composition containing organic-zirconia composite fine particles, a photopolymerization initiator and polymerizable compounds, and the present invention has been completed.
Namely, the present invention provides, according to a first aspect, a photosensitive composition used for forming a pattern by a pattern exposure containing (a) a polymerizable compound, (b) a photopolymerization initiator and (c) organic-zirconia composite fine particles having a zirconia volume concentration of 20% by volume to 80% by volume;
according to a second aspect, the photosensitive composition according to the first aspect, used for forming a pattern in which by a pattern exposure, a mass transfer of the composition is caused and a spatial distribution of a component is changed;
according to a third aspect, the photosensitive composition according to the first aspect, used for forming a hologram by an interference exposure;
according to a fourth aspect, the photosensitive composition according to the first aspect, in which the (a) polymerizable compound is a compound providing a polymer having a refractive index of 1.3 to 1.7 relative to a wavelength of an interference exposure for a hologram recording;
according to a fifth aspect, the photosensitive composition according to the fourth aspect, in which a difference between a refractive index of the (c) organic-zirconia composite fine particles relative to the wavelength of an interference exposure for the hologram recording and a refractive index of the polymer relative to the wavelength of an interference exposure for the hologram recording, is 0.01 or more and 1.0 or less;
according to a sixth aspect, the photosensitive composition according to the first aspect, in which zirconia particles as a core of the (c) organic-zirconia composite fine particles have an average particle diameter of 3 nm or more and 30 nm or less;
according to a seventh aspect, the photosensitive composition according to the first aspect, in which a ratio of a mass of the (c) organic-zirconia composite fine particles of a total mass of the (a) polymerizable compound, the (b) photopolymerization initiator and the (c) organic-zirconia composite fine particles is 3% by mass to 70% by mass;
according to an eighth aspect, the photosensitive composition according to the first aspect, in which the (a) polymerizable compound is a compound having an ethylenic unsaturated bond and the (b) photopolymerization initiator is a photo radical polymerization initiator;
according to a ninth aspect, the photosensitive composition according to the first aspect, in which the (a) polymerizable compound is a compound having a cation polymerizable site and the (b) photopolymerization initiator is a photoacid generator;
according to a tenth aspect, a hologram recording layer, manufactured by applying the photosensitive composition according to the first aspect on a support;
according to an eleventh aspect, a hologram recording medium containing a support, a hologram recording layer obtained by applying the photosensitive composition according to the first aspect on the support, and a protecting material covering an upper layer of the hologram recording layer;
according to a twelfth aspect, the hologram recording medium according to the eleventh aspect, in which both the support and the protecting material are a transparent resin film;
according to a thirteenth aspect, a forming method of a pattern including applying the photosensitive composition according to the first aspect on a support to form a coating film, and subjecting the coating film to a pattern exposure; and
according to a fourteenth aspect, the forming method of a pattern according to the thirteenth aspect, in which the pattern exposure is an interference exposure.

### [Effects of the Invention]

According to the present invention, a photosensitive composition capable of forming a pattern by a pattern exposure can be provided.
By subjecting the photosensitive composition of the present invention to a pattern exposure, a pattern caused by a change in a spatial distribution of components in the composition can be formed. Particularly, a hologram can be formed by an interference exposure.
In addition, by using the photosensitive composition of the present invention, a hologram recording layer can be provided. By subjecting the hologram recording layer to an interference exposure, a hologram can be recorded.
According to the present invention, a hologram having a low light scattering loss and high diffraction efficiency can be provided.

To the hologram obtained according to the present invention, other optical functionalities can be imparted. The holographic diffraction grating can be applied, as a multifunctional optical element, to wide fields such as photonics and information displays, for example, a diffraction optical element, a holographic optical memory, a narrow band wavelength filter, a photonic crystal, an optical waveguide coupler, an optical interconnection, a stereoscopic image display and a heads-up display.

### BEST MODES FOR CARRYING OUT THE INVENTION

The photosensitive composition of the present invention contains (a) a polymerizable compound, (b) a photopolymerization initiator and (c) organic-zirconia composite fine particles having a zirconia volume concentration of 20% by volume to 80% by volume. Hereinafter, each component will be described.

### (a) Polymerizable compound

The polymerizable compound of the present invention is not particularly limited so long as the compound has one or more, preferably one to six polymerizable site(s) which is polymerized by an action of a photopolymerization initiator in a molecule thereof. The polymerizable site includes, for example, an ethylenic unsaturated bond which is a radical polymerizable site. Examples of other polymerizable sites include a vinylether structure, a vinylthioether structure and a cyclic ether structure such as an epoxy ring or an oxetane ring, which is a cation polymerizable site.
In addition, the polymerizable compound of the present invention means a compound which is not a so-called polymer substance. Accordingly, the polymerizable compound encompasses not only narrowly defined monomer compounds, but also dimmers, trimmers, oligomers and reactive polymers.
Such polymerizable compound includes, for example, compounds having an ethylenic unsaturated bond which is a radical polymerizable site. Examples of other polymerizable compounds include compounds having a vinylether structure, an epoxy ring or an oxetane ring which are cation polymerizable sites.

Examples of the compound having an ethylenic unsaturated bond include: unsaturated carboxylic acids; ester compounds between aliphatic polyhydroxy compounds and unsaturated carboxylic acids; ester compounds between aromatic polyhydroxy compounds and unsaturated carboxylic acids; ester compounds obtained by an esterification reaction between polyhydroxy compounds such as aliphatic polyhydroxy compounds and aromatic polyhydroxy compounds, and unsaturated carboxylic acids and polycarboxylic acids; and amide compounds between aliphatic polyamine compounds and unsaturated carboxylic acids.
Specifically, examples thereof include: unsaturated aliphatic acids; ester compounds between aliphatic polyhydroxy compounds and unsaturated carboxylic acids; and ester compounds between aromatic polyhydroxy compounds and unsaturated carboxylic acids.
Examples thereof also include: ester compounds between alicyclic polyhydroxy compounds and unsaturated carboxylic acids; and ester compounds obtained by an esterification reaction between polyhydroxy compounds of alicyclic polyhydroxy compounds and unsaturated carboxylic acids and polycarboxylic acids.

Specific examples of the unsaturated aliphatic acid include phenoxyethylene glycol acrylate, phenoxydiethylene glycol acrylate, 2-hydroxy-3-phenoxypropyl acrylate, 3-chloro-2-hydroxypropyl methacrylate, 2-acryloyloxyethyl succinic acid, 2-acryloyloxyethyl phthalic acid, and isobornyl acrylate. Examples thereof also include: methacrylic ester compounds produced by substituting an acrylate portion of these acrylic ester compounds with methacrylate; itaconate ester compounds produced by substituting with itaconate in a similar manner as above; crotonate ester compounds produced by substituting with crotonate; and maleate ester compounds produced by substituting with maleate.
In addition, examples thereof include cyclohexyl acrylate and adamantyl acrylate. Examples thereof also include: methacrylic ester compounds produced by substituting an acrylate portion of these acrylic ester compounds with methacrylate, itaconate ester compounds produced by substituting with itaconate in a similar manner as above, crotonate ester compounds produced by substituting with crotonate, and maleate ester compounds produced by substituting with maleate.

Specific examples of the ester compound between aliphatic polyhydroxy compounds and unsaturated carboxylic acids include: acrylic ester compounds such as ethylene glycol diacrylate, triethylene glycol diacrylate, trimethylolpropane triacrylate, trimethylolethane triacrylate, pentaerythritol diacrylate, pentaerythritol triacrylate, pentaerythritol tetraacrylate, dipentaerythritol tetraacrylate, dipentaerythritol pentaacrylate, dipentaerythritol hexaacrylate, and glycerol acrylate. Examples thereof also include methacrylic ester compounds produced by substituting an acrylate portion of these acrylic ester compounds with methacrylate, itaconate ester compounds produced by substituting with itaconate in a similar manner as above, crotonate ester compounds produced by substituting with crotonate, and maleate ester compounds produced by substituting with maleate.
In addition, examples of the ester compound include alkylene glycol diacrylate such as 1,6-hexanediol diacrylate and polybutanediol diacrylate. Examples thereof also include methacrylic ester compounds produced by substituting an acrylate portion of these acrylic ester compounds with methacrylate, itaconate ester compounds produced by substituting with itaconate in a similar manner as above, crotonate ester compounds produced by substituting with crotonate, and maleate ester compounds produced by substituting with maleate.
Examples of the ester compound between alicyclic polyhydroxy compounds and unsaturated carboxylic acids include: tricyclodecanedimethanol diacrylate and tricyclodecanedimethanol dimethacrylate. Examples thereof also include methacrylic ester compounds produced by substituting an acrylate portion of these acrylic ester compounds with methacrylate, itaconate ester compounds produced by substituting with itaconate in a similar manner as above, crotonate ester compounds produced by substituting with crotonate, and maleate ester compounds produced by substituting with maleate.

Examples of the ester compound between aromatic polyhydroxy compounds and unsaturated carboxylic acids include hydroquinone diacrylate, hydroquinone dimethacrylate, resorcin diacrylate, resorcin dimethacrylate and pyrogallol triacrylate.
In addition, examples thereof include bisphenol A diacrylate and bisphenol F diacrylate. Examples thereof also include methacrylic ester compounds produced by substituting an acrylate portion of these acrylic ester compounds with methacrylate, itaconate ester compounds produced by substituting with itaconate in a similar manner as above, crotonate ester compounds produced by substituting with crotonate, and maleate ester compounds produced by substituting with maleate.

Representative specific examples of the ester compound obtained by an esterification reaction between polyhydroxy compounds such as aliphatic polyhydroxy compounds and aromatic polyhydroxy compounds, and unsaturated carboxylic acids and polycarboxylic acids which are not necessarily a single substance include a condensate of acrylic acid, phthalic acid and ethylene glycol, a condensate of acrylic acid, maleic acid and diethylene glycol, a condensate of methacrylic acid, terephthalic acid and pentaerythritol, and a condensate of acrylic acid, adipic acid, butanediol and glycerin.

Examples of a compound having an ethylenic unsaturated bond include: urethane compounds that can be obtained by a reaction between polyisocyanate and hydroxy alkyl-unsaturated carboxylic acid ester; and compounds that can be obtained by a reaction between polyvalent epoxy compounds and hydroxyalkyl-unsaturated carboxylic acid ester.
Useful examples of the compound having an ethylenic unsaturated bond used in the present invention include acrylamide compounds such as ethylene bisacrylamide, allyl ester compounds such as diallyl phthalate, and vinyl group-containing compounds such as divinyl phthalate.
In the present invention, particularly preferred examples of the compound having an ethylenic unsaturated bond include acrylic ester compounds or methacrylic ester compounds.
These compounds having an ethylenic unsaturated bond may be used individually or, if necessary in combination of two or more types thereof.

Examples of a compound having a vinylether structure include vinyl 2-chloroethyl ether, vinyl n-butyl ether, triethylene glycol divinyl ether, 1,4-cyclohexanedimethanol divinyl ether, trimethylolethane trivinyl ether and vinyl glycidyl ether.

Examples of a compound having an epoxy ring include diglycerol polydiglycidyl ether, pentaerythritol polyglycidyl ether, 1,4-bis(2,3-epoxypropoxyperfluoroisopropyl) cyclohexane, sorbitol polyglycidyl ether, trimethylolpropane polyglycidyl ether, resorcin diglycidyl ether, 1,6-hexanediol diglycidyl ether, polyethylene glycoldiglycidyl ether, phenyl glycidyl ether, p-tert-butylphenyl glycidyl ether, adipic acid diglycidyl ether, o-phthalic acid diglycidyl ether, dibromophenyl glycidyl ether, 1,2,7,8-diepoxyoctane, 1,6-dimethylolperfluorohexane diglycidyl ether, 4,4'-bis(2,3-epoxypropoxyperfluoroisopropyl) diphenyl ether, 2,2-bis(4-glycidyloxyphenyl) propane, 3,4-epoxycyclohexylmethyl 3',4'-epoxycyclohexane carboxylate, 3,4-epoxycyclohexyl oxirane, 2-(3,4-epoxycyclohexyl)-3',4'-epoxy-1,3-dioxane-5-spirocyclohexane, 1,2-ethylenedioxy bis(3,4-epoxycyclohexylmethane), 4',5'-epoxy-2'-methylcyclohexylmethyl 4,5-epoxy-2-methylcyclohexane carboxylate, ethylene glycol bis(3,4-epoxycyclohexane carboxylate), bis-(3,4-epoxycyclohexylmethyl) adipate, and di-2,3-epoxycyclopentyl ether.

Examples of a compound having an oxetane ring include: compounds having one oxetane ring such as 3-ethyl-3-hydroxymethyloxetane, 3-ethyl-3-(phenoxymethyl) oxetane, 3,3-diethyloxetane and 3-ethyl-3-(2-ethylhexyloxymethyl) oxetane; and compounds having two or more oxetane rings such as 1,4-bis(((3-ethyl-3-oxetanyl) methoxy) methyl) benzene, di(1-ethyl(3-oxetanyl))methyl ether and pentaerythritol tetrakis(3-ethyl-3-oxetanylmethyl) ether.

### (b) Photopolymerization initiator

The photopolymerization initiator of the present invention is not particularly limited so long as the initiator is a compound having a function capable of initiating a polymerization of the above polymerizable compound by a pattern exposure.
Examples of the method of the pattern exposure include a photo mask exposure, a phase mask exposure and an interference exposure. Among them, the interference exposure is preferred.
The light source for the interference exposure may be generally a laser light having high interference which is only necessary to be high sensitive relative to the photopolymerization initiator, and a laser such as an argon ion laser (458 nm, 488 nm, 514.5 nm), a krypton ion laser (647.1 nm), an Nd:YAG laser (532 nm), an Nd:YVO₄ laser (532 nm) and an InGaN laser (405 nm), is used.

When the compound having an ethylenic unsaturated bond is used as the polymerizable compound, as the photopolymerization initiator, preferred is a photo radical polymerization initiator which generates an activated radical during a pattern exposure.
When the compound having a vinylether structure, an epoxy ring or an oxetane ring which is a cation polymerizable site is used as the polymerizable compound, as the photopolymerization initiator, preferred is a photoacid generator which generates a Lewis acid or a Broensted acid during the interference exposure.

The photo radical polymerization initiator is not particularly limited so long as it is a compound which generates an activated radical during the pattern exposure. However, examples thereof including azo-based compounds, azide-based compounds, diazo-based compounds, o-quinonediazide-based compounds, organic peroxides, benzophenones, bis-coumarin, bis-imidazol compounds, titanocene compounds, organic thiol compounds, halogenated hydrocarbon compounds, trichloromethyltriazine compounds or onium salt compounds such as iodonium salt compounds and sulfonium salt compounds, are used. Among them, titanocene compounds are preferred.
The photo radical polymerization initiator may be used individually or, if necessary in combination of two or more types thereof.

The titanocene compound is not particularly limited, however, specific examples thereof include dicyclopentadienyl-titanium-dichloride, dicyclopentadienyl-titanium-bisphenyl, dicyclopentadienyl-titanium-bis(2,3,4,5,6-pentafluorophenyl), dicyclopentadienyl-titanium-bis(2,3,5,6-tetrafluorophenyl), dicyclopentadienyl-titanium-bis(2,4,6-trifluorophenyl), dicyclopentadienyl-titanium-bis(2, 6-difluorophenyl), dicyclopentadienyl-titanium-bis(2,4,-difluorophenyl), bis(methylcyclopentadienyl)-titanium-bis(2,3,4,5,6-pentafluorophenyl), bis(methylcyclopentadienyl)-titanium-bis(2,3,5,6-tetrafluorophenyl), bis(methylcyclopentadienyl)-titanium-bis(2,6-difluorophenyl) and dicyclopentadienyl-titanium-bis(2,6-difluoro-3-(1H-pyrrol-1-yl)-phenyl).

Examples of the azide-based compound include p-azidebenzaldehyde, p-azideacetophenone, p-azide benzoic acid, p-azidebenzalacetophenone, 4,4'-diazidechalcone, 4,4'-diazidediphenylsulfide, 2,6-bis(4'-azidebenzal)-4-methylcyclohexanone and α-cyano-4,4'-dibenzostilbene.

Examples of the azo-based compound include 1,2-naphthoqinone-diazide(2)-4-sulfonic acid sodium salt, 1,2-naphthoqinone-diazide(2)-5-sulfonic ester and 1,2-naphthoqinone-diazide(2)-4-sulfonyl chloride.

Examples of the diazo-based compound include 1-diazo-2,5-diethoxy-4-p-tolylmercaptobenzeneborofluoride, 1-diazo-4-N,N-dimethylaminobenzenechloride and 1-diazo-4-N,N-diethylaminobenzeneborofluoride.

Examples of the o-quinonediazide-based compound include 1,2-naphthoquinone-diazide(2)-4-sulfonic acid sodium salt, 1,2-naphthoquinonediazide(2)-5-sulfonic ester and 1,2-naphthoquinone-diazide(2)-4-sulfonyl chloride.

Examples of the benzophenones include benzophenone, 4,4'-bisdiethylaminobenzophenone, 1,4-dibenzoylbenzene, 10-butyl-2-chloroacridone, 2-benzoylnaphthalene, 4-benzoyl biphenyl, 4-benzoyl diphenyl ether and benzil.

Examples of the bis-coumarin include 3,3'-carbonylbis(7-(diethylamino)-2H-chromen-2-one) which is commercially available from Midori Kagaku Co., Ltd. as BC (CAS(63226-13-1)).

Examples of the bis-imidazol compound include 2,2'-bis(o-chlorophenyl)-4,5,4',5'-tetrakis(3,4,5-trimethoxyphenyl)1,2'-bisimidazol and 2,2'-bis(o-chlorophenyl) 4,5,4',5'-tetraphenyl-1,2'-bisimidazol.

The photoacid generator is not particularly limited so long as it is a compound which generates a Lewis acid or a Broensted acid during a pattern exposure, however, examples thereof include: onium salt compounds such as diaryl iodonium salt compounds, triaryl sulfonate compounds and diazonium salt compounds; and iron-arene complex compounds.

Examples of the diaryl iodonium salt compound include tetrafluoroborate, hexafluorophosphate, hexafluoroarsenate and hexafluoroantimonate of iodonium such as diphenyl iodonium, 4,4'-dichlorodiphenyl iodonium, 4,4'-dimethoxydiphenyl iodonium, 4,4'-di-tert-butyldiphenyl iodonium, (4-methylphenyl)(4-(2-methylpropyl) phenyl) iodonium and 3,3'-dinitrophenyl iodonium.

Examples of the triaryl sulfonate compound include tetrafluoroborate, hexafluorophosphate, hexafluoroarsenate and hexafluoroantimonate of sulfonium such as triphenyl sulfonium, 4-tert-butyl triphenyl sulfonium, tris(4-methylphenyl) sulfonium, tris(4-methoxyphenyl) sulfonium and 4-thiophenyl triphenyl sulfonium.

Examples of the iron arene complex compound include biscyclopentadienyl-(η6-isopropylbenzene)-iron (II) hexafluorophosphate.
The photoacid generator may be used individually or, if necessary in combination of two or more types thereof.

When in the photosensitive composition of the present invention, a compound having an ethylenic unsaturated bond which is a radical polymerizable site is used as the polymerizable compound, as the photopolymerization initiator, basically, a photo radical-polymerization initiator is used. When as the polymerizable compound, compounds having a vinylether structure, an epoxy ring or an oxetane ring which are cation-polymerizable sites are used, basically, a photoacid generator is used as the photopolymerization initiator.

### (c) Organic-zirconia composite fine particles

The organic-zirconia composite fine particles are not particularly limited so long as they are organic-zirconia composite fine particles having a zirconia volume concentration of 20% by volume to 80% by volume, and particles constituted of zirconia capable of achieving the object of the present invention. However, they need to lower a light scattering loss, so that they are desirably organic-zirconia composite fine particles in which zirconia particles which become the core of organic-zirconia composite fine particles have an average particle diameter of 30 nm or less. The zirconia particles as the core have an average particle diameter of, for example, 3 nm to 30 nm, preferably 3 nm to 20 nm, more preferably 3 nm to 10 nm.

The form of zirconia to be used may be a powdered state or a sol dispersed in water or an organic solvent, however, in terms of dispersibility in the photosensitive composition of the present invention and stability, a sol dispersed in an organic solvent is preferred.

The average particle diameter of zirconia particles as the core of the organic-zirconia composite fine particles of nanometer order can be measured by a transmission electron microscope (TEM). Here, the average particle diameter is measured as 50% diameter (D₅₀: median diameter) of the number-based cumulative size distribution of the particle diameter (length).

The organic-zirconia composite fine particles used in the present invention have a zirconia volume concentration of 20% by volume to 80% by volume, preferably 40% by volume to 70% by volume. When the zirconia volume concentration is 20% by volume or less, since the content of organic substances having a relatively small refractive index becomes large, the refractive index of the whole particles becomes small and the difference in the refractive index between the composite fine particles and the polymerizable compound becomes small, so that the refractive index modulation after the exposure is lowered, which leads to the lowering of the diffraction efficiency during the hologram recording. On the other hand, when the zirconia volume concentration is 80% by volume or more, the agglomeration of particles to each other becomes likely to be caused, so that the light scattering loss is increased and the diffraction efficiency is lowered during the hologram recording.

When the organic-zirconia composite fine particles used are in the state of a sol in which the fine particles are dispersed in a solvent, the measurement method of the volume fraction of zirconia used in the present invention is derived by measuring the specific gravity (mass of the composite fine particles) after removing the organic solvent under a volatilization condition of the organic solvent used and by measuring the specific gravity (mass of zirconia) by cleaning the resultant substances with a solvent or the like after calcining organic substances at 500°C or more.

Since mass of organic substances = mass of composite fine particles - mass of zirconia, the volume fraction of zirconia can be obtained from (mass of zirconia /specific gravity of zirconia) / ((mass of zirconia / specific gravity of zirconia) + (mass of organic substances / specific gravity of organic substances)).

In addition, the organic components used in the organic-zirconia composite fine particles of the present invention may be any compound and may be treated by any treating method so long as the dispersibility of the zirconia particles is enhanced.
Examples of the method include encapsulation, surface treatment and hybridization, however, a modification using a surface treating agent is preferred in terms of industrial easiness.
The surface treating agent is preferably that having affinity with the zirconia surface and having both surface reactive functional groups and hydrophobic groups for enhancing the dispersibility in the polymerizable compound.

Examples of the surface reactive functional group include: reactive silane compounds, for example, alkyl silanes such as methyl silane and ethyl silane, alkoxy silanes such as methoxy silane and ethoxy silane, and halogenated silanes such as chlorosilane; reactive titanium compounds, for example, titanium chloride, and alkoxy titanium such as methoxy titanium and ethoxy titanium; carboxyl groups; phosphoric acid groups; sulfonic acid groups; and esters thereof.

On the other hand, examples of the hydrophobic group include a site constituted generally with hydrocarbons such as alkyl chains and aromatic rings and having hydrophobicity. As the hydrophobic group, resins can be used and examples thereof include general resins such as acrylic resins, polyester resins, polyether resins, urethane resins, silicone resins, epoxy resins and vinyl acetate resins.

Examples of the surface treating agent include a basic structure of a resin-type pigment dispersant having acidic functional groups as a surface reactive functional group. Examples thereof include general resins such as acrylic resins, polyester resins, polyether resins, urethane resins, silicone resins, epoxy resins and vinyl acetate resins.
Examples of the commercially available resin-type pigment dispersant having acidic functional groups include Solsperse 3000, Solsperse 21000, Solsperse 26000, Solsperse 36600, and Solsperse 41000 (manufactured by Avecia Biologics Limited); Disperbyk 108, Disperbyk 110, Disperbyk 111, Disperbyk 112, Disperbyk 168, Disperbyk 180, and Disperbyk 2001 (manufactured by BYK Japan KK); DISPARLON 3600N and DISPARLON 1850 (manufactured by Kusumoto Chemicals, Ltd.); PA 111 (manufactured by Ajinomoto Fine-Techno Co., Inc.); and EFKA4401 and EFKA4550 (manufactured by Ciba Inc.), which is not limited in the scope of these.

In a method for obtaining organic-zirconia composite fine particles, when the raw material is an aqueous zirconia sol, as the production method of the aqueous zirconia sol, for example, a method for hydrolyzing an aqueous solution of zirconium salt by application of heat, a method for adding hydrogen peroxide water to an aqueous solution of zirconium salt and heating, and a method for heating zirconium hydroxide in a basic region, are known.

In Japanese Patent Application Publication JP-A-3-174325, there is described a method for hydrolyzing a reaction product of zirconium ammonium carbonate and a chelating agent (for example, oxyphenols, aminoalcohols, oxyacids, polycarboxylic acids, oxyaldehydes, amino acids, β-diketones).

In Japanese Patent Application Publication JP-A-64-83519, there is described a production method of a basic zirconia sol including: retaining an aqueous suspension containing zirconium hydroxide in a heating state at a temperature of 80°C or more until the crystallinity of the generated zirconia becomes 80% or more to obtain an aqueous suspension containing crystallized zirconia; and adding to the obtained suspension, basic compounds containing nitrogen (primary amine, secondary amine, quaternary ammonium hydroxide) or hydroxides of alkali metals or alkaline earth metals.

In Japanese Patent Application Publication JP-A-60-176920, there is described a production method of a zirconia sol including: adding a base to an aqueous solution of a zirconium salt to be precipitated; adding a hydroxide of an alkaline earth metal or an aqueous solution thereof to the solution containing the resultant precipitate; and aging the resultant suspension by heating at a temperature of 90 to 200°C.

In International Publication WO 2006 / 019004 pamphlet, there are described a production method of a stable alkaline metal oxide sol having a uniform particle diameter distribution including: heating a metal compound in an aqueous medium containing quaternary ammonium carbonate salt at 60 to 110°C; and subjecting the reaction product to a hydrothermal treatment at 110 to 250°C, and a production method of a zirconia sol as an example of the above production method of a metal oxide sol.

The organic-zirconia composite fine particles used in the present invention can be obtained by a production method including the following processes (a) and (b), when an aqueous zirconia sol obtained by the above method is used. A process (a): a process of removing water from the aqueous zirconia sol to obtain a powder of zirconia particles and a process (b): a process of adding a resin-type pigment dispersant and an organic solvent to the powder of zirconia particles obtained in the process (a) to disperse them.

In the process (a) in the production method of the present invention which is a process of removing water from an aqueous zirconia sol, it is preferred that after removing water by hot-air drying or spray-dry drying, the zirconia sol is ground with a dry mill to obtain a powder of zirconia particles.

The process (b) in the production method of the present invention is a process of adding a resin-type pigment dispersant having acid functional groups and an organic solvent to the powder of zirconia particles obtained in the process (a) to disperse the powder. Examples of the used dispersing machine include a paint conditioner (manufactured by Red Devil Equipment Co.), a ball mill, a sand mill ("Dyno-mill" etc., manufactured by Shinmaru Enterprises Corporation), an attritor, a pearl mill ("DCP mill" manufactured by Maschinenfabrik Gustav Eirich GmbH & Co.
KG, etc.), a coball mill, a homomixer, a homogenizer ("Clearmix" manufactured by M Technique Co., Ltd., etc.) and a wet jet mill ("Genus PY" manufactured by Genus Co., Ltd., "nanomizer" manufactured by Nanomizer Co., Ltd., etc.). Further, when media are used in the dispersing machine, glass beads, zirconia beads, alumina beads, magnetic beads, styrene beads, or the like is preferred.

In addition, when as a raw material, a powder of zirconia particles is used, known is an invention in which the production method of a powder of zirconia particles has a process of producing the above aqueous zirconia sol and a process of pulverizing the sol.
As an example thereof, in Japanese Patent Application Publication JP-A-2006-016236, described is a production method of a powder of zirconia particles, having a feature that a basic solution is added to a metal salt solution to neutralize partially the metal salt solution; then an inorganic salt is added to the partially neutralized solution to prepare a mixed solution; and the mixed solution is heated and then dried.
In this case, organic-zirconia composite fine particles can be obtained in the process (b).

In addition, the production method of the organic-zirconia composite fine particles used in the present invention is not only the above method, but also any production method, commercially available products may also be purchased. For example, preferably used are an organic solvent dispersion of tetragonal zirconia particles having a dispersion particle diameter of 1 nm or more and 20 nm or less which is produced by using, as a surface treating agent, one type or two or more types of compound selected from the group consisting of alkoxy silane compounds, siloxane compounds, surfactants and titanium coupling agents which is described in Japanese Patent Application Publication No. JP-A-2007-119617 (corresponding international application: International Publication WO 2007 / 049573 pamphlet), and an organic solvent dispersion of tetragonal zirconia particles having a dispersion particle diameter of 1 nm or more and 20 nm or less which is described in Japanese Patent Application Publication No. JP-A-2007-99931. More preferred is a nano zirconia dispersion (product name) in which organic-zirconia composite fine particles having an average particle diameter of 3 to 10 nm and having a zirconia content of 25% by volume to 50% by volume are dispersed in an organic solvent (toluene), which is commercially available from Sumitomo Osaka Cement Co., Ltd.

As a pattern such as a hologram, an interference pattern of light is recorded by utilizing the difference in a refractive index between at least two components contained in a recording layer.
Therefore, in the present invention, under a condition of a pattern exposure for forming a pattern, for example, under a condition of an interference exposure for recording a hologram, it is necessary that there is a difference between the refractive index of a polymer generated from the above polymerizable compound and the refractive index of organic-zirconia composite fine particles. For example, it is necessary that there is a difference of 0.01 to 1.0 between the refractive index of the polymer and the refractive index of the organic-zirconia composite fine particles.

For example, it is necessary that the difference between the refractive index of the organic-zirconia composite fine particles relative to a wavelength of light used for the interference exposure for recording the hologram and the refractive index of the polymer generated from a polymerizable compound under a condition of the interference exposure relative to a wavelength of light used for the interference exposure for recording the hologram, is 0.01 to 1.0, or 0.02 to 0.50, or 0.03 to 0.15. Thus, from such a viewpoint, the organic-zirconia composite fine particles and the polymerizable compound are selected.

Then, the polymerizable compound needs to have a large refractive index difference from that of the organic-zirconia composite fine particles and the organic-zirconia composite fine particles have a relatively high refractive index. Thus, preferably used is a compound which provides a polymer having, as a refractive index of the organic-zirconia composite fine particles used in the present invention, a relatively low refractive index in which a refractive index relative to a wave length of light used for the interference exposure for recording the hologram is 1.3 to 1.7. For example, preferably used is a compound which provides a polymer having a refractive index of 1.3 to 1.7 relative to light having a wavelength of 589 nm. More preferably used is a compound which provides a polymer having a refractive index of 1.3 to 1.6 relative to light having a wavelength of 589 nm.

The refractive index of the polymer can be obtained by applying a composition containing a polymerizable compound and a photopolymerization initiator on a support; drying the coated support, if necessary; and then applying a spatially uniform exposure to the composition under a condition using light used for the interference exposure for recording the hologram to obtain a polymer; and measuring the refractive index of the obtained polymer. Then, based on the refractive index of the thus obtained polymer and the refractive index of the organic-zirconia composite fine particles, the polymerizable compound and the organic-zirconia composite fine particles for the composition for the hologram recording material of the present invention can be selected.

In the photosensitive composition of the present invention, besides the above components (a) to (c), if necessary, additives such as polymerization inhibitors, sensitizers, chain transfer agents, plasticizers, colorants may be incorporated. In addition, in order to maintain the uniformity of the film thickness, to cause the hologram formed by the polymerization with irradiating light to exist stably, and further to reduce the shrinkage rate of the hologram, binder resins may be incorporated as a combined agent.

As the binder resin, an oligomer or a polymer having a molecular weight of 1,000 or more which has advantageous compatibility with a radical polymerizable compound and a cation polymerizable compound, is dissolved in uncured photosensitive composition to be a transparent uniform solution and does not cause a strong light scattering due to a phase separation of several hundreds nm or more after the curing, can be used.

The polymerization inhibitor is generally a compound retarding or inhibiting the polymerization and is not particularly limited in the present invention. However, examples of the polymerization inhibitor for the radical polymerization include phenol, catechol, benzoquinone, hydroquinone, esters thereof, etherified products thereof, alkylated products thereof which are hindered phenols, phenothiazine, hindered amines, hydroxyamines such as TEMPO and nitrosamines. Examples thereof for the cation polymerization include compounds exhibiting basicity and preferred examples thereof include organic amines.

The photo radical polymerization initiator of the present invention may be used individually or in combination with a sensitizer which is a component absorbing light.
Preferred examples of the sensitizer include: pyrromethene complexes such as 2,6-diethyl-1,3,5,7,8-pentamethylpyrromethene-BF2 complex and 1,3,5,7,8-pentamethylpyrromethene-BF₂ complex; xanthene-type dyes such as eosin, ethyleosin, erythrosine, fluorescein and rose bengal; ketothiazoline-type compounds such as 1-(1-methylnaphtho(1,2-d)thiazol-2(1H)-ylidene-4-(2,3,6,7) tetrahydro-1H, 5H-benzo(ij)quinolidine-9-yl)-3-butene-2-one, and 1-(3-methylbenzothiazol-2(3H)-ylidene-4-(p-dimethylaminophenyl)-3-butene-2-one; styryl- or phenylbutadienyl heterocyclic compounds such as 2-(p-dimethylaminostyryl)-naphtho(1,2-d) thiazol and 2-(4-(p-dimethylaminophenyl)-1,3-butadienyl)-naphtho(1,2-d) thiazol; triazine compounds such as 2,4-diphenyl-6-(p-dimethylaminostyryl)-1,3,5-triazine and 2,4-diphenyl-6-(((2,3,6,7)tetrahydro-1H,5H-benzo(ij)quinolidine-9-yl)-1-ethene-2-yl)-1,3,5-triazone; aminophenyl unsaturated ketone compounds such as 9-phenanthryl-(((2,3,6,7)tetrahydro-1H, 5H-benzo(ij)quinolidine-9-yl)-1-ethene-2-yl)ketone and 2,5-bis(p-dimethylaminocinnamylidene) cyclopentanone; or porphyrins such as 5,10,15,20-tetraphenylporphyrin and hematoporphyrin. Among them, particularly pyrromethene complexes are preferred, and in an application in which colorless-transparency relative to visible light is required, cyanine-type dyes are preferred.

When titanocene compounds are used as a photo radical polymerizable initiator, as a sensitizer, benzophenones, bis-coumarin, bis-imidazol compounds and pyrromethene compounds are preferably used.

In addition, by using thiol, alkyl amines, amino acids which are hydrogen donors, it is possible to enhance the sensitivity, and examples of thiol include 2-benzoxazolethiol and 2-benzothiazolethiol and examples of amino acids include N-phenylglycine and 4-cyano-N-phenylglycine.

The photo cation polymerization initiator of the present invention may also be used individually or in combination with a sensitizer which is a component absorbing light. Examples of the sensitizer which can be used in the present invention include carbazole derivatives such as carbazole, N-ethyl carbazole, N-vinyl carbazole and N-phenyl carbazole; naphthalene derivatives such as 1-naphthol, 2-naphthol, 1-methoxynaphthalene, 1-stearyloxynaphthalene, 2-methoxynaphthalene, 2-dodecyloxynaphthalene, 4-methoxy-1-naphthol, glycidyl 1-naphthyl ether, 2-(2-naphthoxy)ethyl vinyl ether, 1,4-dihydroxynaphthalene, 1,5-dihydroxynaphthalene, 1,6-dihydroxynaphthalene, 2,7-dihydroxynaphthalene, 2,7-dimethoxynaphthalene, 1,1'-thiobis(2-naphthol), 1,1'-bi-2-naphthol, 1,5-naphthyldiglycidyl ether, 2,7-di(2-vinyloxyethyl)naphthyl ether, 4-methoxy-1-naphthol and condensates of naphthol derivatives and formalin; anthracene derivatives such as 9,10-dimethoxyanthracene, 2-ethyl-9,10-dimethoxyanthracene, 2-tert-butyl-9,10-dimethoxyanthracene, 2,3-dimethyl-9,10-dimethoxyanthracene, 9-methoxy-10-methylanthracene, 9,10-diethoxyanthracene, 2-ethyl-9,10-diethoxyanthracene, 2-tert-butyl-9,10-diethoxyanthracene, 2,3-dimethyl-9,10-diethoxyanthracene, 9-ethoxy-10-methylanthracene, 9,10-dipropoxyanthracene, 2-ethyl-9,10-dipropoxyanthracene, 2-tert-butyl-9,10-dipropoxyanthracene, 2,3-dimethyl-9,10-dipropoxyanthracene, 9-isopropoxy-10-methylanthracene, 9,10-dibenzyloxyanthracene, 2-ethyl-9,10-dibenzyloxyanthracene, 2-tert-butyl-9,10-dibenzyloxyanthracene, 2,3-dimethyl-9,10-dibenzyloxyanthracene, 9-benzyloxy-10-methylanthracene, 9,10-di-α-methylbenzyloxyanthracene, 2-ethyl-9,10-di-α-methylbenzyloxyanthracene, 2-tert-butyl-9,10-di-α-methylbenzyloxyanthracene, 2,3-dimethyl-9,10-di-α-methylbenzyloxyanthracene, 9-(a-methylbenzyloxy)-10-methylanthracene, 9,10-di(2-hydroxyethoxy)anthracene and 2-ethyl-9,10-di(2-carboxyethoxy)anthracene; chrysene derivatives such as 1,4-dimethoxychrisene, 1,4-diethoxychrisene, 1,4-dipropoxychrisene, 1,4-dibenzyloxychrisene and 1,4-di-α-methylbenzyloxychrisene; and phenanthrene derivatives such as 9-hydroxyphenanthrene, 9,10-dimethoxyphenanthrene and 9,10-diethoxyphenanthrene. Among these derivatives, particularly 9,10-dialkoxyanthracene derivative which may have an alkyl group having 1 to 4 carbon atoms as a substituent is preferred, and as the alkoxy group, a methoxy group and an ethoxy group are preferred.

In addition, examples of the thioxanthone derivative include thioxanthone, 2,4-dimethylthioxanthone, 2,4-diethylthioxanthone, isopropylthioxanthone and 2-chlorothioxanthone.

The above radical initiator such as titanocene compounds such as dicyclopentadienyl-titanium is known to act as a sensitizer of the photoacid generator and in this case, a photoacid generator and a radical polymerization initiator or a photoacid generator, a radical polymerization initiator and a sensitizer for the radical polymerization initiator can be used in combination, respectively.
The amount of the sensitizer is necessary to be varied depending on the thickness of the medium used, however, is 0.0 1 % to 10%, and preferably 0.1% to 5% in mass ratio to the mass of the polymerization initiator.

The binder resin is preferably that having advantageous compatibility with the polymerizable compound and specific examples thereof include polyacrylic acid; polymethacrylic acid; poly(meth)acrylic ester such as polymethyl acrylate, polymethyl methacrylate, polyethyl acrylate, polybutyl acrylate, polymethacrylonitrile, polyethyl methacrylate and polybutyl methacrylate; polyvinyl acetate; polyvinyl butyrate; polyvinyl formal; polyvinyl carbazole; polyacrylonitrile; poly-1,2-dichloroethylene; ethylene-vinyl acetate copolymer; syndiotactic-type polymethyl methacrylate; poly-α-vinylnaphthalate; polycarbonate; cellulose acetate; cellulose triacetate; cellulose acetate butyrate; polystyrene; poly-α-methylstyrene; poly-o-methylstyrene; poly-p-methylstyrene; poly-p-phenylstyrene; poly-2,5-dichlorostyrene; poly-p-chlorostyrene; poly-2,5-dichlorostyrene; polyarylate; polysulphone; polyethersulphone; styrene-acrylonitrile copolymer; styrenedivinylbenzene copolymer; styrene-butadiene copolymer; styrene-maleic anhydride copolymer; ABS resin; polyethylene; polyvinyl chloride; polypropylene; polyethylene terephthalate; polyvinylpyrrolidone; polyvinylidene chloride; transparent polyurethane; polytetrafluoroethylene; polyvinylidene fluoride; and copolymers thereof.
The above exemplified compounds of a binder polymer may be used individually or in combination of two or more types thereof.

For forming a pattern from the photosensitive composition of the present invention, first by applying the composition on an appropriate support such as a resin film, a coating film is formed. Next, the coating film is subjected to a pattern exposure. The pattern exposure is not particularly limited so long as it is an exposure method capable of forming a pattern. Examples of the pattern exposure include an interference exposure and also include a method for exposing to light through an appropriate mask (photomask exposure, phasemask exposure, or the like).

The photosensitive composition of the present invention contains polymerizable compounds, photopolymerization initiators, and organic-zirconia composite fine particles. Therefore, for example, when an exposure is performed through a mask, in a part exposed to light, a polymerization reaction of a polymerizable compound is effected to produce a polymer. As a result, in an exposed part, the chemical potential of the polymerizable compound is reduced and so as to compensate it, the polymerizable compound is moved from a non-exposed part to an exposed part. On the other hand, in an exposed part, following the reduction of the polymerizable compound, the chemical potential of the organic-zirconia composite fine particles which are not involved in the photopolymerization is increased, therefore, so as to suppress it, the organic-zirconia composite fine particles are moved from an exposed part to a non-exposed part. Such movements of each component are substantially continued until the photopolymerization is completed. As a result, the spatial distribution of the organic-zirconia composite fine particles is fixed and due to the components and density difference between in the exposed part and in the non-exposed part, a pattern is formed. In other words, the pattern formed by the photosensitive composition of the present invention is that utilizing the difference in the spatial distribution of each component caused as a result of a mutual diffusion of each component in the composition caused by the pattern exposure.

For producing the hologram recording layer with using the photosensitive composition of the present invention, first by mixing polymerizable compounds, photopolymerization initiators and organic-zirconia composite fine particles, if necessary together with additives such as a sensitizer and a binder resin and by applying the resultant mixture on a support, or by adding a solvent to the resultant mixture to mix them and then by applying the mixture on a support, and if necessary by drying the coated product, a hologram recording layer is formed on a support to obtain a hologram recording medium. In addition, by covering the top of the hologram recording layer with a protecting material, a hologram recording medium can be produced. The hologram recording layer has a thickness of, for example 1 to 1000 µm, or 30 to 500 µm, or 50 to 200 µm.

Examples of the solvent include acetone, methyl ethyl ketone, methyl isobutyl ketone, cyclohexanone, toluene, xylene, tetrahydrofuran, methylcellosolve, ethylcellosolve, methylcellosolve acetate, ethyl acetate, 1,4-dioxane, 1,2-dichloroethane, dichloromethane, chloroform, methanol, ethanol, isopropanol and mixed solvent thereof. The solvent can be used in a mass of 0.5 to 20 times the total mass of the components (a) to (c).

Examples of the support include a transparent glass plate and a transparent acryl plate. In addition, as the support, a transparent resin film such as a polyethylene terephthalate film and a polyethylene film can be used.

As the method for applying the photosensitive composition of the present invention on a support, besides a method for dropping the composition directly, a conventionally heretofore known method such as rotation coating, wire bar coating, dip coating, air-knife coating, roll coating, blade coating and curtain coating can be used.

As the protecting material, a heretofore known material for preventing an adverse affect such as lowering of the sensitivity and impairment of preservation stability due to oxygen can be used. Examples thereof include a transparent resin film such as a polyethylene terephthalate film and a polyethylene film. In addition, a resin film formed by applying with a water-soluble polymer or the like can be used.

The photosensitive composition of the present invention contains organic-zirconia composite fine particles and polymerizable compounds. Then, in the hologram recording layer obtained from the composition, organic-zirconia composite fine particles are dispersed in polymerizable compounds, so that the difference in the refractive index between a bright section and dark section of the interference pattern becomes large. Thus, the recording layer obtained from the composition becomes a hologram recording layer capable of forming a hologram having high diffraction efficiency.

Next, the hologram recording method using the hologram recording layer of the present invention is described. First, when two laser lights coherent to each other are simultaneously irradiated to a hologram recording medium having the hologram recording layer of the present invention, interference stripes in which a bright section and a dark section line side by side in a streak form is formed on the hologram recording layer. In the case of such a spatially unequal light irradiation, in the bright section, as more polymerizable compounds are consumed to be converted into polymers, the chemical potential of the polymerizable compound is reduced and so as to compensate it, from a dark section to a bright section, the polymerizable compound is moved (diffused). On the other hand, in a bright section, following the reduction of the polymerizable compound, the chemical potential of the organic-zirconia composite fine particles which are not involved in the photopolymerization is increased, therefore, so as to suppress it, the organic-zirconia composite fine particles are back-diffused from a bright section to a dark section. Such mutual diffusion process is substantially continued until the photopolymerization is completed. As a result, the spatial distribution of the organic-zirconia composite fine particles is fixed and due to the composition and density difference between in the bright section and in the dark section, a refractive index grating (hologram) is formed and the hologram is recorded. During the reproduction, when a reproduction light is irradiated to a region in which the hologram is formed, a diffraction is caused and a hologram image is reproduced.

In addition, the refractive index modulation of the volume phase hologram is generally determined by the total sum of the product of the volume ratio and a refractive index of the constituents. Though the moving amounts of the polymerizable compounds and the organic-zirconia composite fine particles are an important factor for enlarging the refractive index modulation, the amount of the organic-zirconia composite fine particles which can be dispersed in the composition is limited, so that when the amount is too large, the organic-zirconia composite fine particles are unlikely to be dispersed. On the other hand, when the amount is too small, a steady refractive index modulation cannot be enlarged.

Therefore, in the photosensitive composition of the present invention, it is preferred that the mass ratio of the organic-zirconia composite fine particles constitutes, for example 3% by mass to 60% by mass, or 10% by mass to 50% by mass, or 20% by mass to 40% by mass of the total mass of the (a) polymerizable compound, the (b) photopolymerization initiator and the (c) organic-zirconia composite fine particles. In addition, the ratio of the polymerizable compound is, for example 35% by mass to 92% by mass, or 47% by mass to 87% by mass, or 58% by mass to 78% by mass of the total mass of the polymerizable compound, the photopolymerization initiator and the organic-zirconia composite fine particles. Further, the ratio of the photopolymerization initiator is, for example 0.01 % by mass to 5% by mass, or 0.1 % by mass to 3% by mass, or 0.5% by mass to 2% by mass.

In addition, when the photosensitive composition of the present invention contains other components other than the components (a) to (c) (with the proviso that the solvent is excepted), the content thereof which is a mass 0.0001 to 1 time, or 0.01 to 0.5 times the total mass of the components (a) to (c), may be used.
Next, the present invention will be more specifically described referring to Examples.

### [Examples]

### [Example 1]

### Preparation of the photosensitive composition

0.232 g of a polymerizable compound: tricyclodecanedimethanol dimethacrylate was added to 2.137 g of organic-zirconia composite fine particles dispersion (trade name: Nano-zirconia toluene dispersion; manufactured by Sumitomo Osaka Cement Co., Ltd.; dispersed in toluene, zirconia concentration by mass: 10.4% by mass, the average particle diameter of zirconia particles as the core: 4 nm, zirconia concentration by volume in organic-zirconia composite fine particles: approx. 30% by volume) to disperse homogeneously and thereafter, the resultant dispersion was concentrated to the total mass of 0.587 g, followed by dissolving 0.0023 g of a photopolymerization initiator: dicyclopentadienyl-titanium-bis(2,6-difluoro-3-(1H-pyrrol-1-yl)-phenyl) (trade name: Irgacure 784; manufactured by Ciba Inc.) in the dispersion to prepare a photosensitive composition.
In the dispersion, with respect to the zirconia portion in the organic-zirconia composite fine particles, the zirconia concentration is 10.4% by mass and the density of zirconia particles is 6.0 g/cm³, so that the volume of zirconia is 2.137 × 0.104 / 6.0 = 0.037 cm³. The organic portion in the organic-zirconia composite fine particles can be calculated from the amount of the residue obtained by subjecting the composite particles to a heat treatment. 1.4 mg of the dispersion were dried at 120°C and the residue thereof was 0.20 mg. Zirconia has a concentration of 10.4% by mass, thus it is 0.14 mg. Consequently the organic portion is 0.06 mg. When assumed that the specific gravity of the organic portion is 1, in the volume ratio, the organic portion is 2.5 relative to 1 of the zirconia. The volume of the organic-zirconia composite fine particles per 2.137 g of the dispersion is 0.037 + (0.037 × 2.5) = 0.1295 cm³.
Accordingly, in the photosensitive composition, the density of the organic polymerizable compound is 1.105 g / cm³, so that the volume thereof is 0.2099 cm³. Therefore, the concentration of the organic-zirconia composite fine particles has constituted 38% by volume (0.1295 / (0.1295 + 0.2099) = 0.38) of the total volume of the organic-zirconia composite fine particles and the polymerizable compound.

### Measurement of each physical property during the hologram recording

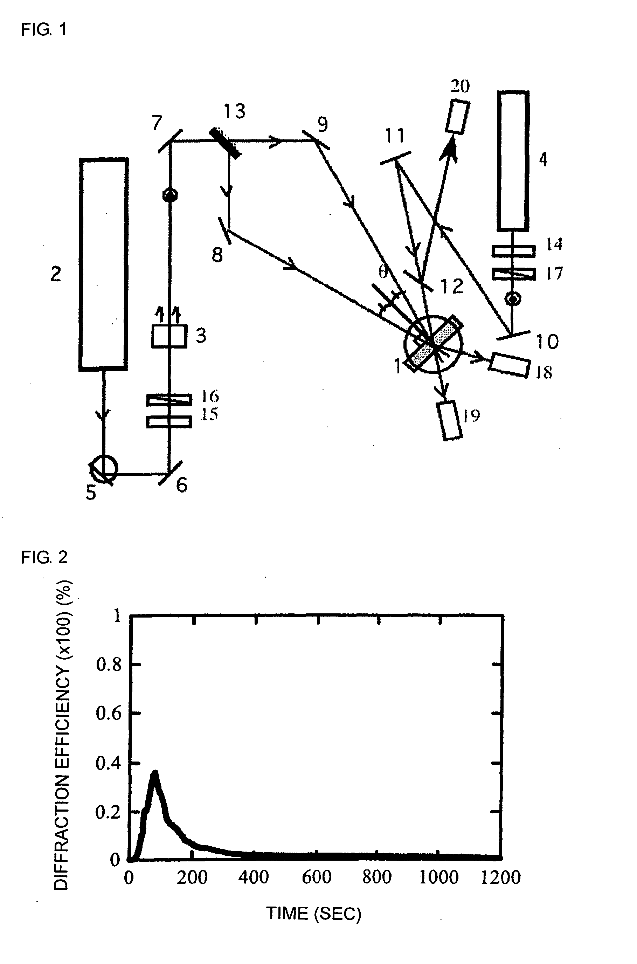

On both edge of a slide glass, a polyethylene terephthalate film having a thickness of 50 µm as a spacer was laminated and the above photosensitive composition was dropped to the center of the slide glass (area sandwiched with the spacers), followed by drying the slide glass in an oven at 80°C for approx. 60 minutes to form a hologram recording layer. Thereafter, the slide glass was covered with another slide glass to prepare a volume phase hologram recording medium having a thickness of approx. 36 µm.
By subjecting the present recording medium to a two-beam interference exposure by an apparatus shown in FIG. 1, the recording of a volume hologram was attempted. A hologram recording medium was subjected to a two-beam interference exposure (grating interval: 1 µm) using an Nd:YVO₄ laser having a wavelength of 532 nm at an exposure power density of 100 mW/cm². Light irradiated from the Nd:YVO₄ laser through a beam expander is divided into two beams by a half mirror. Each of the two beams is irradiated through mirrors to the hologram recording medium and intensity-interference fringe pattern of the two beams are recorded to form a hologram.
Simultaneously, a helium-neon (He-Ne) laser having a wavelength of 632.8 nm by which a hologram recording medium is not exposed was irradiated to the hologram recording medium and diffracted light was detected by a photodetector to monitor a hologram forming process, and the diffraction efficiency is evaluated.
In addition, by measuring the angular dependence of the diffraction efficiency after the exposure, the film thickness of the sample was calculated to evaluate the modulated amount of the refractive index (Δn). Further, to the hologram recording medium after the exposure, a helium-neon (He-Ne) laser having a wavelength of 632.8 nm was irradiated and from the ratio of irradiated light and diffracted light + transmitted light, the scattering loss was evaluated.

### [Example 2]

In substantially the same manner as in Example 1, a sample having a volume fraction of organic-zirconia composite fine particles of 28% was prepared to evaluate each physical property.

### [Example 3]

In substantially the same manner as in Example 1, a sample having a volume fraction of organic-zirconia composite fine particles of 46% was prepared to evaluate each physical property.

### [Example 4]

0.234 g of a polymerizable compound: p-bis(β-methacryloyloxyethylthio) xylylene was added to 1.326 g of organic-zirconia composite fine particles dispersion (trade name: Nano-zirconia toluene dispersion; manufactured by Sumitomo Osaka Cement Co., Ltd.; dispersed in toluene, zirconia concentration by mass: 10.4% by mass, the average particle diameter of zirconia particles as the core: 4 nm, zirconia concentration by volume in organic-zirconia composite fine particles: approx. 30% by volume) to disperse homogeneously and thereafter, the resultant dispersion was concentrated to the total mass of 0.5063 g, followed by dissolving 0.0023 g of a photopolymerization initiator: dicyclopentadienyl-titanium-bis(2,6-difluoro-3-(1H-pyrrol-1-yl)-phenyl) (trade name: Irgacure 784; manufactured by Ciba Inc.) in the dispersion to prepare a photosensitive composition.
In the dispersion, with respect to the zirconia portion in the organic-zirconia composite fine particles, the zirconia concentration is 10.4% by mass and the density of zirconia particles is 6.0 g/cm³, so that the volume of zirconia is 1.326 × 0.104 / 6.0 = 0.023 cm³. The volume of the organic-zirconia composite fine particles calculated in substantially the same manner as in Example 1 is 0.023 + (0.023 × 2.5) = 0.0805 cm³. The density of the polymerizable compound is 1.13 g / cm³, so that the volume thereof is 0.2068 cm³.
Therefore, the concentration of the organic-zirconia composite fine particles has constituted 28% by volume (0.0805 / (0.0805 + 0.2068) = 0.28) of the total volume of the organic-zirconia composite fine particles and the polymerizable compound.
In substantially the same manner as in Example 1, each physical property was evaluated.

### [Example 5]

In substantially the same manner as in Example 4, a sample having a volume fraction of organic-zirconia composite fine particles of 46% was prepared to evaluate each physical property.

### [Example 6]

### Preparation of the photosensitive composition

2.32 g of a polymerizable compound: tricyclodecanedimethanol dimethacrylate was added to 21.37 g of organic-zirconia composite fine particles dispersion (trade name: Nano-zirconia toluene dispersion; manufactured by Sumitomo Osaka Cement Co., Ltd.; dispersed in toluene, zirconia concentration by mass: 10.4% by mass, the average particle diameter of zirconia particles as the core: 4 nm, zirconia concentration by volume in organic-zirconia composite fine particles: approx. 30% by volume) to disperse homogeneously and thereafter, the resultant dispersion was concentrated to the total mass of 5.87 g, followed by dissolving 0.023 g of a photopolymerization initiator: dicyclopentadienyl-titanium-bis(2,6-difluoro-3-(1H-pyrrol-1-yl)-phenyl) (trade name: Irgacure 784; manufactured by Ciba Inc.) and · 0.0016 g of a sensitizing dye: 1,3,5,7,8-pentamethyl-2,6-di-tert-butyl-pyrrometene-difluoroborate salt (trade name: pyrromethene 597; manufactured by Exciton Inc.) in the dispersion to prepare a photosensitive composition.
In the dispersion, with respect to the zirconia portion in the organic-zirconia composite fine particles, the zirconia concentration is 10.4% by mass and the density of zirconia particles is 6.0 g/cm³, so that the volume of zirconia is 21.37 × 0.104 / 6.0 = 0.37 cm³. The volume of the organic-zirconia composite fine particles calculated in substantially the same manner as in Example 1 is 0.37 + (0.37 × 2.5) = 1.295 cm³. The density of the polymerizable compound is 1.105 g / cm³, so that the volume thereof is 2.099 cm³.
Therefore, the concentration of the organic-zirconia composite fine particles has constituted 38% by volume (1.295 / (1.295 + 2.099) = 0.38) of the total volume of the organic-zirconia composite fine particles and the polymerizable compound.

### Measurement of each physical property during the hologram recording

Each physical property was evaluated in substantially the same manner as in Example 1.
By adding a sensitizing dye, at an exposing power density of 1 mW/cm², the modulated amount of the refractive index became Δn = 3.2 × 10⁻³, so that the exposing power density could be lowered by 1 digit or more compared to the case where the dye is not added.

### [Example 7]

### Preparation of the photosensitive composition

0.232 g of a polymerizable compound: tricyclodecanedimethanol dimethacrylate was added to 2.137 g of organic-zirconia composite fine particles dispersion (trade name: Nano-zirconia toluene dispersion; manufactured by Sumitomo Osaka Cement Co., Ltd.; dispersed in toluene, zirconia concentration by mass: 10.4% by mass, the average particle diameter of zirconia particles as the core: 4 nm, zirconia concentration by volume in organic-zirconia composite fine particles: approx. 30% by volume) to disperse homogeneously and thereafter, the resultant dispersion was concentrated to the total mass of 0.587 g, followed by dissolving 0.0023 g of a photopolymerization initiator: dicyclopentadienyl-titanium-bis(2,6-difluoro-3-(1H-pyrrol-1-yl)-phenyl) (trade name: Irgacure 784; manufactured by Ciba Inc.), 0.0012 g of a sensitizing dye: 3,3'-carbonyl bis(7-diethylaminocoumarin) (trade name: BC; manufactured by Midori Kagaku Co., Ltd.) and 0.0046 g of an additive: N-phenyl glycine (manufactured by Tokyo Chemical Industry Co., Ltd.) in the dispersion to prepare a photosensitive composition.
In the dispersion, with respect to the zirconia portion in the organic-zirconia composite fine particles, the zirconia concentration is 10.4% by mass and the density of zirconia particles is 6.0 g/cm³, so that the volume of zirconia is 2.137 × 0.104 / 6.0 = 0.037 cm³. The volume of the organic-zirconia composite fine particles calculated in substantially the same manner as in Example 1 is 0.037 + (0.037 × 2.5) = 0.1295 cm³. The density of the polymerizable compound is 1.105 g / cm³, so that the volume thereof is 0.2099 cm³.
Therefore, the concentration of the organic-zirconia composite fine particles has constituted 38% by volume (0.1295 / (0.1295 + 0.2099) = 0.38) of the total volume of the organic-zirconia composite fine particles and the polymerizable compound.

### Measurement of each physical property during the hologram recording

Each physical property was evaluated in substantially the same manner as in Example 1.
By adding a sensitizing dye, at an exposing power density of 1 mW/cm², the modulated amount of the refractive index became Δn = 3.3 × 10⁻³, so that the exposing power density could be lowered by 1 digit or more compared to the case where the dye is not added.

### [Example 8]

### Preparation of the photosensitive composition

0.232 g of a polymerizable compound: tricyclodecanedimethanol dimethacrylate was added to 0.637 g of organic-zirconia composite fine particles dispersion (trade name: Nano-zirconia toluene dispersion; manufactured by Sumitomo Osaka Cement Co., Ltd.; dispersed in toluene, zirconia concentration by mass: 10.4% by mass, the average particle diameter of zirconia particles as the core: 4 nm, zirconia concentration by volume in organic-zirconia composite fine particles: approx. 30% by volume) to disperse homogeneously and 0.0023 g of a photopolymerization initiator: dicyclopentadienyl-titanium-bis(2,6-difluoro-3-(1H-pyrrol-1-yl)-phenyl) (trade name: Irgacure 784; manufactured by Ciba Inc.) were dissolved in the resultant dispersion. 0.695 g of polymethyl methacrylate (weight average molecular weight Mw = 120,000) as a binder were dissolved in 3.5 g of toluene and the resultant solution was mixed with the above homogeneous composition of the polymerizable compound, zirconia and the photopolymerization initiator to prepare a photosensitive composition.
In the dispersion, with respect to the zirconia portion in the organic-zirconia composite fine particles, the zirconia concentration is 10.4% by mass and the density of zirconia particles is 6.0 g/cm³, so that the volume of zirconia is 0.637 × 0.104 / 6.0 = 0.011 cm³. The volume of the organic-zirconia composite fine particles calculated in substantially the same manner as in Example 1 is 0.011 + (0.011 × 2.5) = 0.0385 cm³. The density of the polymerizable compound is 1.105 g / cm³, so that the volume thereof is 0.2099 cm³.
Therefore, the concentration of the organic-zirconia composite fine particles has constituted 15% by volume (0.0385 / (0.0385 + 0.2099) = 0.15) of the total volume of the organic-zirconia composite fine particles and the polymerizable compound.

### Measurement of each physical property during hologram recording

Each physical property was evaluated in substantially the same manner as in Example 1. By adding polymethyl methacrylate as a binder, the volume shrinkage rate of the hologram recording material composition between before and after the exposure could be largely suppressed to 0.1 %.

### [Example 9]

0.232 g of a polymerizable compound: tricyclodecanedimethanol diacrylate (trade name: A-DCP; manufactured by Shin-nakamura Chemical Co., LTD.) was added to 1.302 g of organic-zirconia composite fine particles dispersion (trade name: NZD-8JF91-E; manufactured by Sumitomo Osaka Cement Co., Ltd.; dispersed in toluene, the concentration of organic-zirconia composite fine particles: 13.7% by mass, the average particle diameter of zirconia particles as the core: 3 to 4 nm) to disperse homogeneously and thereafter, the resultant dispersion was concentrated to the total mass of 0.50 g, followed by dissolving 0.0023 g of a photopolymerization initiator: dicyclopentadienyl-titanium-bis(2,6-difluoro-3-(1H-pyrrol-1-yl)-phenyl) (trade name: Irgacure 784; manufactured by Ciba Inc.) in the dispersion to prepare a photosensitive composition.
In the dispersion, the concentration of the organic-zirconia composite fine particles is 13.7% by mass and the density of the organic-zirconia composite fine particles is 1.98 g/cm³, so that the volume of the organic-zirconia composite fine particles is 1.302 × 0.137 / 1.98 = 0.090 cm³.
Therefore, in the photosensitive composition, the density of the organic polymerizable compound is 1.105 g / cm³, so that the volume thereof is 0.210 cm³. Therefore, the concentration of the organic-zirconia composite fine particles has constituted 30% by volume (0.090 / (0.090 + 0.210) = 0.30) of the total volume of the organic-zirconia composite fine particles and the polymerizable compound.

### Measurement of each physical property during hologram recording

On both edge of a slide glass, an aluminum foil having a thickness of 10 µm as a spacer was sandwiched and the above photosensitive composition was dropped to the center of the slide glass (area sandwiched with spacers), followed by drying the slide glass in an oven at 80°C for approx. 60 minutes to form a hologram recording layer. Each physical property of the present recording medium was measured in substantially the same manner as in Example 1.

### [Example 10]

In substantially the same manner as in Example 9, a sample having a volume fraction of organic-zirconia composite fine particles of 10% was prepared to evaluate each physical property.

### [Example 11]

In substantially the same manner as in Example 9, a sample having a volume fraction of organic-zirconia composite fine particles of 20% was prepared to evaluate each physical property.

### [Example 12]

In substantially the same manner as in Example 9, a sample having a volume fraction of organic-zirconia composite fine particles of 25% was prepared to evaluate each physical property.

### [Example 13]

In substantially the same manner as in Example 9, a sample having a volume fraction of organic-zirconia composite fine particles of 35% was prepared to evaluate each physical property.

### [Example 14]

In substantially the same manner as in Example 9, a sample having a volume fraction of organic-zirconia composite fine particles of 40% was prepared to evaluate each physical property.

### [Example 15]

In substantially the same manner as in Example 9, a sample having a volume fraction of organic-zirconia composite fine particles of 45% was prepared to evaluate each physical property.

### [Example 16]

0.232 g of a polymerizable compound: tricyclodecanedimethanol diacrylate (trade name: A-DCP; manufactured by Shin-nakamura Chemical Co., LTD.) was added to 2.045 g of organic-zirconia composite fine particles dispersion (trade name: NCI-003P; manufactured by Sumitomo Osaka Cement Co., Ltd.; dispersed in toluene, the concentration of organic-zirconia composite fine particles: 12.1% by mass, the average particle diameter of zirconia particles as the core: 3 to 4 nm) to disperse homogeneously and thereafter, the resultant dispersion was concentrated to the total mass of 0.68 g, followed by dissolving 0.0023 g of a photopolymerization initiator: dicyclopentadienyl-titanium-bis(2,6-difluoro-3-(1H-pyrrol-1-yl)-phenyl) (trade name: Irgacure 784; manufactured by Ciba Inc.) in the dispersion to prepare a photosensitive composition.
In the dispersion, the concentration of the organic-zirconia composite fine particles is 12.1% by mass and the density of the organic-zirconia composite fine particles is 2.75 g/cm³, so that the volume of the organic-zirconia composite fine particles is 2.045 × 0.121/2.75 = 0.090 cm³.
Therefore, in the photosensitive composition, the density of the organic polymerizable compound is 1.105 g / cm³, so that the volume thereof is 0.210 cm³. Therefore, the concentration of the organic-zirconia composite fine particles has constituted 30% by volume (0.090 / (0.090 + 0.210) = 0.30) of the total volume of the organic-zirconia composite fine particles and the polymerizable compound.

### Measurement of each physical property during hologram recording

On both edge of a slide glass, an aluminum foil having a thickness of 10 µm as a spacer was sandwiched and the above photosensitive composition was dropped to the center of the slide glass (area sandwiched with spacers), followed by drying the slide glass in an oven at 80°C for approx. 60 minutes to form a hologram recording layer. Each physical property of the present recording medium was measured in substantially the same manner as in Example 1.

### [Example 17]

In substantially the same manner as in Example 16, a sample having a volume fraction of organic-zirconia composite fine particles of 10% was prepared to evaluate each physical property.

### [Example 18]

In substantially the same manner as in Example 16, a sample having a volume fraction of organic-zirconia composite fine particles of 20% was prepared to evaluate each physical property.

### [Example 19]

In substantially the same manner as in Example 16, a sample having a volume fraction of organic-zirconia composite fine particles of 25% was prepared to evaluate each physical property.

### [Example 20]

In substantially the same manner as in Example 16, a sample having a volume fraction of organic-zirconia composite fine particles of 35% was prepared to evaluate each physical property.

### [Example 21]

In substantially the same manner as in Example 16, a sample having a volume fraction of organic-zirconia composite fine particles of 40% was prepared to evaluate each physical property.

**(Table 1)**

| Examples | Refractive index modulated amount (×10⁻³) | Film thickness (µm) | Scattering loss (%) | Exposure strength (mW/cm²) | Volume shrinkage rate (%) |
|---|---|---|---|---|---|
| 1 | 3.8 | 36.3 | Less than 1% (below detection limit) | 10 | |
| 2 | 2.4 | 8.7 | Less than 1% (below detection limit) | 10 | |
| 3 | 3.4 | 49.3 | Less than 1% (below detection limit) | 10 | |
| 4 | 0.58 | 13.3 | Less than 1% (below detection limit) | 100 | |
| 5 | 0.92 | 45.7 | Less than 1% (below detection limit) | 100 | |
| 6 | 3.2 | 29.4 | Less than 1% (below detection limit) | 1 | |
| 7 | 3.3 | - | Less than 1% (below detection limit) | 1 | |
| 8 | 0.2 | - | Less than 1% (below detection limit) | 100 | 0.1 |
| 9 | 6.8 | 21 | Less than 1% (below detection limit) | 100 | |
| 10 | 2.8 | 10 | Less than 1% (below detection limit) | 100 | |
| 11 | 5.0 | 12 | Less than 1% (below detection limit) | 100 | |
| 12 | 5.5 | 15 | Less than 1% (below detection limit) | 100 | |
| 13 | 6.2 | 23 | Less than 1% (below detection limit) | 100 | |
| 14 | 5.6 | 33 | Less than 1% (below detection limit) | 100 | |
| 15 | 5.3 | 31 | Less than 1% (below detection limit) | 100 | |
| 16 | 8.5 | 27 | Less than 1% (below detection limit) | 100 | |
| 17 | 3.2 | 13 | Less than 1% (below detection limit) | 100 | |
| 18 | 6.5 | 20 | Less than 1% (below detection limit) | 100 | |
| 19 | 7.3 | 24 | Less than 1% (below detection limit) | 100 | |
| 20 | 4.8 | 35 | Less than 1% (below detection limit) | 100 | |
| 21 | 3.0 | 34 | Less than 1% (below detection limit) | 100 | |

### [Comparative Example 1]

A volume phase hologram recording medium having a film thickness of approx. 44 µm was produced in substantially the same manner as in Example 1, except that zirconia particles were not contained. By subjecting the present recording medium to a two-beam interference exposure using an apparatus shown in FIG. 1 in substantially the same manner as in Example 1, the recording of a volume phase hologram was performed. The diffraction efficiency was once elevated, however, was lowered with time and finally, almost disappeared. This corresponds to such a phenomenon that the refractive index modulation disappears when the whole is polymerized, since this recording medium is a single component of a polymerizable component. See FIG. 2.

### [Comparative Example 2]

### Preparation of the photosensitive composition

0.032 g of a photopolymerization initiator: dicyclopentadienyl-titanium-bis(2,6-difluoro-3-(1H-pyrrol-1-yl)-phenyl) (trade name: Irgacure 784; manufactured by Ciba Inc.) were dissolved in 10.0 g of a silica dispersion (trade name: MEK-ST (SNOWTEX), manufactured by Nissan Chemical Industries, Ltd.; dispersed in methyl ethyl ketone, 30.5% by mass, an average particle diameter: approx. 11 to 13 nm) and to the resultant solution, 3.16 g of a polymerizable compound: p-bis(β-methacryloyloxyethylthio) xylylene was added to prepare a homogeneous solution, to thereby preparing a photosensitive composition.
As the density of the silica particles is 2.1 g/cm³, the volume thereof is 3.05/2.1 = 1.4524 cm³. As the density of the polymerizable compound is 1.13 g/cm³, the volume thereof is 2.7965 cm³. Therefore, the concentration of silica has constituted 34% by volume (1.4524/(1.4524 + 2.7965) = 0.34) of the total volume of silica and the polymerizable compound.

### Measurement of each physical property during hologram recording

Each physical property was measured in substantially the same manner as in Example 1.
At the film thickness of approx. 35 µm and the exposure intensity of 100 mW/cm², Δn = 6.3 × 10⁻³ and the scattering loss was approx. 3%.

### [Comparative Example 3]

In substantially the same manner as in Comparative Example 2, a volume phase hologram recording medium having a film thickness of approx. 66 µm was prepared and each physical property was evaluated. As a result, at the exposure intensity of 100 mW/cm², Δn = 5.6 × 10⁻³ and the scattering loss was approx. 4%.

### [Comparative Example 4]

In substantially the same manner as in Comparative Example 2, a volume phase hologram recording medium having a film thickness of approx. 100 µm was prepared and each physical property was evaluated. As a result, at the exposure intensity of 100 mW/cm², Δn = 6.0 × 10⁻³ and the scattering loss was approx. 11%.

### [Reference Example 1]

Here, the preparing method of a similar product to a dispersion in an organic solvent (toluene) of organic-zirconia composite fine particles used in Examples 1 to 8 is described below.

### Preparation of a powder of zirconia particles

A diluted ammonia water in which 886 g of 28% ammonia water were dissolved in 20 L of pure water was added to a zirconium salt solution in which 2615 g of zirconium oxychloride octahydrate were dissolved in 40 L of pure water while stirring the mixture to prepare a zirconia precursor slurry.
To the slurry, a potassium carbonate solution in which 300 g of potassium carbonate were dissolved in 5 L of pure water was added while stirring the mixture. At this time, the added amount of potassium carbonate was 30% by mass relative to a value of zirconium ion in the zirconium salt solution converted into zirconia.
The resultant mixture was dried using a drier in the atmosphere at 130°C for 24 hours to obtain a solid product. Next, the solid product was ground by an automatic mortar and thereafter, was sintered using an electric oven in the atmosphere at 500°C for 1 hour.
The resultant sintered product was charged into pure water and stirred to prepare a slurry. Thereafter, the slurry was cleaned using a centrifuge to remove fully the added potassium carbonate and then the resultant slurry was dried using a drier to prepare a zirconia powder.
The yield of the powder of zirconia particles was 98%, the specific surface area thereof measured by a nitrogen adsorption method (BET method) was 180 m²/g, and the average particle diameter measured by TEM was 4 nm.

### Preparation of organic solvent (toluene) dispersion of organic-zirconia composite fine particles

1.2 parts of the obtained a powder of zirconia particles, 0.5 parts of a resin-type pigment dispersant having acidic functional groups (trade name: Disperbyk-111; manufactured by BYK Japan KK.; resin solid content: 97% by mass), 12 parts of toluene and 70 parts of zirconia beads (a diameter: 1.25 mm) were charged into a 70 mL sample bottle and the resultant mixture was dispersed using a paint shaker for 2 hours. The obtained organic solvent (toluene) dispersion of organic-zirconia composite fine particles was a substantially transparent sol.

### BRIEF DESCRIPTION OF THE DRAWINGS

[FIG. 1] FIG. 1 is a conceptual diagram of an apparatus for performing a two-beam interference exposure relative to a volume hologram recording medium.
[FIG. 2] FIG. 2 is a graph showing the change in diffraction efficiency of a volume hologram recording medium according to the exposure time in Comparative Example 1.

### [Description of the Reference Numerals]

- 1: Hologram recording medium
- 2: Nd:YVO₄ lase
- 3: Beam expander
- 4: He-Ne laser
- 5,6,7,8,9,10,11: Mirror
- 12: Beam sampler
- 13: Half mirror
- 14,15: Half-wave plate
- 16,17: Polarizing prism
- 18,19,20: Photodetector

## Claims

1. A photosensitive composition used for forming a pattern by a pattern exposure comprising:
(a) a polymerizable compound;
(b) a photopolymerization initiator; and
(c) organic-zirconia composite fine particles having a zirconia volume concentration of 20% by volume to 80% by volume.

2. The photosensitive composition according to claim 1, wherein a pattern exposure causes a mass transfer of a component and a spatial distribution of a refractive index is changed to form a pattern.

3. The photosensitive composition according to claim 1, used for forming a hologram by an interference exposure.

4. The photosensitive composition according to claim 1, wherein the (a) polymerizable compound is a compound providing a polymer having a refractive index of 1.3 to 1.7 relative to a wavelength of an interference exposure for a hologram recording.

5. The photosensitive composition according to claim 4, wherein a difference between a refractive index of the (c) organic-zirconia composite fine particles relative to the wavelength of an interference exposure for the hologram recording and a refractive index of the polymer relative to the wavelength of an interference exposure for the hologram recording, is 0.01 or more and 1.0 or less.

6. The photosensitive composition according to claim 1, wherein zirconia particles as a core of the (c) organic-zirconia composite fine particles have an average particle diameter of 3 nm or more and 30 nm or less.

7. The photosensitive composition according to claim 1, wherein a ratio of a mass of the (c) organic-zirconia composite fine particles constitutes 3% by mass to 60% by mass of a total mass of the (a) polymerizable compound, the (b) photopolymerization initiator and the (c) organic-zirconia composite fine particles.

8. The photosensitive composition according to claim 1, wherein the (a) polymerizable compound is a compound having an ethylenic unsaturated bond and the (b) photopolymerization initiator is a photo radical polymerization initiator.

9. The photosensitive composition according to claim 1, wherein the (a) polymerizable compound is a compound having a cation polymerizable site and the (b) photopolymerization initiator is a photoacid generator.

10. A hologram recording layer, manufactured by applying the photosensitive composition according to claim 1 on a support.

11. A hologram recording medium comprising:
a support;
a hologram recording layer obtained by applying the photosensitive composition according to claim 1 on the support; and
a protecting material covering an upper layer of the hologram recording layer.

12. The hologram recording medium according to claim 11, wherein both the support and the protecting material are a transparent resin film.

13. A forming method of a pattern comprising:
applying the photosensitive composition according to claim 1 on a support to form a coating film;
and subjecting the coating film to a pattern exposure.

14. The forming method of a pattern according to claim 13, wherein the pattern exposure is an interference exposure.
